# EUROPEAN PATENT SPECIFICATION

(11) **EP 3 879 933 B1**
(45) Date of publication and mention of the grant of the patent: **11.11.2026**
(21) Application number: 21162103.2
(22) Date of filing: 11.03.2021
(51) Int. Cl.: H05B 6/12

(54) **ELECTRIC RANGE AND AIR GUIDE INCLUDED IN THE SAME**
ELEKTRISCHE HERDPLATTE UND LUFTFÜHRUNG DARIN
APPAREIL ÉLECTRIQUE ET GUIDAGE D'AIR INCLUS DANS CELUI-CI

(30) Priority: 12.03.2020 KR 20200030922
(43) Date of publication of application: 15.09.2021
(73) Proprietor: LG Electronics Inc., Seoul 07336 (KR)
(72) Inventor: CHA, Jungmin, Seoul 08592 (KR); CHO, Junghyeon, Seoul 08592 (KR); PARK, Jinwoo, Seoul 08592 (KR)
(74) Representative: Ter Meer und Partner mbB

(56) References cited:
- EP-A1- 3 177 108
- EP-A2- 1 936 283
- EP-B1- 2 498 574
- KR-A- 20180 025 011
- KR-A- 20180 026 141

## Description

### FIELD

Disclosed herein is an electric range, and more particularly, an electric range in which a single air blowing fan can cool a driving circuit configured to control a heating unit, and a display unit configured to display visual information to a user, in a concentrated manner.

### BACKGROUND

Various types of cooking appliances are used to heat food at homes or restaurants. The cooking appliances include gas ranges using gas and electric ranges using electricity.

The electric ranges are classified as resistance heating-type electric ranges and induction heating-type electric ranges.

In a resistance heating method, electric current is supplied to a metallic resistance wire or a non-metallic heat generation element such as silicon carbide to generate heat, and the generated heat is radiated or conducted to heat an object to be heated (e.g., a cooking vessel such as a pot, a frying pan and the like).

In an induction heating method, high-frequency power is supplied to a coil to generate a magnetic field around the coil, and eddy current produced in the generated magnetic field is used to heat an object to be heated made of a metallic material.

Regarding basic theories of induction heating, when electric current is supplied to a working coil or a heating coil, heat is generated while an object to be heated is inductively heated, and the object to be heated is heated by the generated heat.

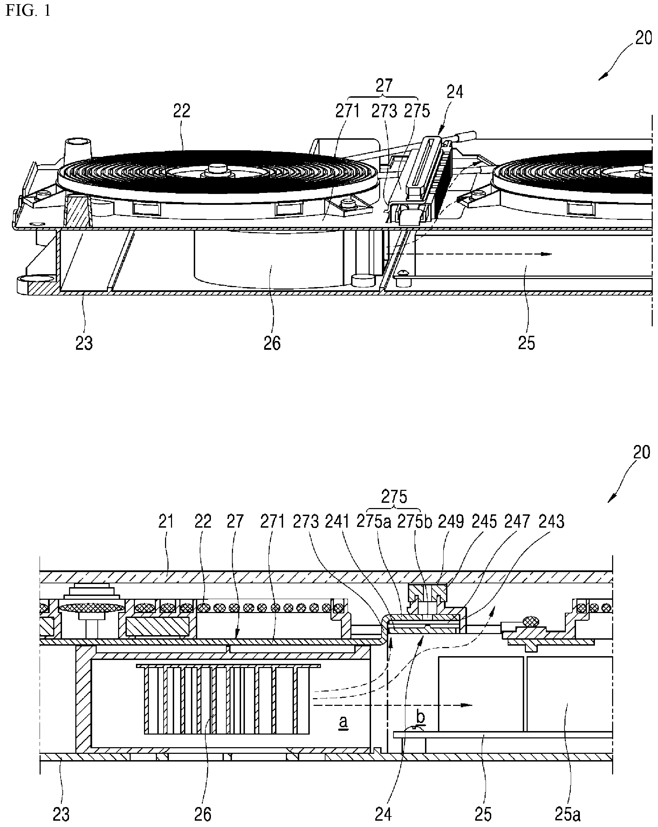

FIG. 1 is a view showing a shape of the related art.

FIG. 1 is presented in Korean Patent Publication No. 10-2018-0026141.

Referring to FIG. 1, a cool air flow inducing member 27 supports a heating unit 22, and guides a flow of cool air blown by a cooling unit 226 to electric components and a light source unit 24. In other words, a cool air flow inducing member 27 is provided between the heating unit 22 and the cooling unit 26, and forms a flow passage of cool air.

However, in the related art, the cold air is only induced to pass through the lower portion of the heating unit 22 and the light source unit 24, and there is a problem in that it is not possible to concentrate high-temperature components among the electric components below the heating unit 22 to cool. In addition, the prior art has a problem in that the light source unit 23 cannot be cooled in a concentrated manner.

KR 2018 0025011 A relates to a cooker. The cooker comprises: a case which has an open upper part and a predetermined space therein; an upper plate unit which is coupled to the upper part of the case to seal the open upper part of the space, and has a surface where food to be cooked is placed on; an electronic part which is provided inside the case; an induction heating part which is provided inside the case, and heats a cooking container through an induction heating method; and a middle plate which has a working coil of the induction heating part installed, and separates a space where the working coil is installed from a lower space thereof. The middle plate has an air influx hole through which air in the lower space of the middle plate moves into the upper space of the middle plate. When the middle plate is divided into an area close to the electronic part and an area far from the electronic part, the air influx hole is provided in the remote area from an operation unit.

EP 1 936 283 A2 presents a cooking appliance. The cooking appliance includes at least one heating element, a heat sink, a cooling fan, and a flow guide. The heat sink is connected to the heating element, to radiate heat. The cooling fan is provided at one side of the heat sink, to blow cooling air to the heat sink. The flow guide covers at least a portion of the heat sink and guides a portion of the cooling air to flow to the heating element.

### SUMMARY

### Technical Problem

The present disclosure is directed to an electric range in which a single air blowing fan may cool all of the driving circuit configured to control a heating unit, and the display unit configured to display visual information to a user, in a concentrated manner.

The present disclosure is directed to an electric range that may reduce noise generated during an operation.

The present disclosure is directed to an electric range that may help to reduce manufacturing costs.

Aspects are not limited to the above ones, and other aspects and advantages that are not mentioned above can be clearly understood from the following description and can be more clearly understood from the embodiments set forth herein.

### Technical Solution

The object is solved by the invention as defined by the features of the independent claim. Preferred embodiments are given by the dependent claims.

In one aspect of the present disclosure an electric range is provided, comprising: a case; a heating unit disposed in the case, and configured to heat an object to be heated; a driving circuit disposed in the case, and configured to drive the heating unit; a display unit disposed at an upper end of the case, and configured to display visual information on an operation of the heating unit to a user; an air blowing fan disposed on a lower surface of the case, and configured to output air; and an air guide configured to guide air output from the air blowing fan to the driving circuit.

The air output from the air blowing fan is supplied to one end of the air guide.

A height of an upper surface of one end of the air guide is greater than a height of an upper surface of the air blowing fan.

Some of the air output from the air blowing fan may be discharged through a gap between the upper surface of one end of the air guide and the upper surface of the air blowing fan, and supplied to the display unit.

In some or more embodiments, the display unit and the air blowing fan may be disposed on a lower side the heating unit.

In some or more embodiments, remaining of the air output from the air blowing fan may be guided to the other end of the air guide.

In some or more embodiments, the display unit may be disposed over the air blowing fan or in an adjacent area over the air blowing fan.

The upper surface of one end of the air guide comprises a first portion and a second portion.

The first portion is disposed in contact with an upper surface of an output end of the air blowing fan.

The gap may be formed between the second portion and the upper surface of the output end of the air blowing fan.

**In** some or more embodiments, the electric range may further comprise a damper member disposed in contact with the upper surface of the air blowing fan

The damper member may be configured to guide air discharged through the gap to the display unit.

**In** some or more embodiments, the display unit may be disposed in an adjacent area over the air blowing fan and one end of the damper member may be disposed in contact with one end of the upper surface of one end of the air guide.

Preferably, the other end of the damper member may be disposed in a direction in which one end of the display unit is placed.

**In** some or more embodiments, the air guide may guide the air output from the air blowing fan to a part of the driving circuit, and a middle end of the air guide may be disposed to encircle a part of the driving circuit.

**In** some or more embodiments, the air output from the air blowing fan and passing through a part of the driving circuit may be output from the other end of the air guide.

A through hole connected to the other end of the air guide may be formed on the lower surface of the case

Air output from the other end of the air guide may be discharged out of the case through the through hole.

The electric range further comprises a heat sink disposed over a part of the driving circuit.

The heat sink is disposed inside the middle end of the air guide.

**In** some or more embodiments, the some of the air may be discharged through the gap by colliding with one end of the heat sink or by air pressure between the heat sink and the air blowing fan.

**In** some or more embodiments, the electric range may further comprise a cover plate coupled to the upper end of the case.

**In** some or more embodiments, the display unit may include a light source unit configured to emit light to a light display area formed on the cover plate.

**In** some or more embodiments, the display unit may include an input interface buried into the upper surface of the cover plate and configured to display a specific image and receive an input from a user.

**In** some or more embodiments, the air guide may be manufactured through single processing.

**In** another aspect of the disclosure an electric range is given, comprising: a case, a heating unit disposed in the case, and configured to heat an object to be heated; a driving circuit disposed in the case, and configured to drive the heating unit; a heat sink disposed over a part of the driving circuit, and configured to cool a part of the driving circuit; a display unit disposed at an upper end of the case, and configured to display visual information on an operation of the heating unit to a user; an air blowing fan disposed on a lower surface of the case to encircle the heat sink, and configured to output air; an air guide configured to guide air, output from the air blowing fan, to a part of the driving circuit

Preferably, a height of at least a part of one end of the air guide is greater than a height of an output end of the air blowing fan.

Some of the air output from the air blowing fan colliding with one end of the heat sink and then may be discharged through a gap between at least a part of one end of the air guide and the output end of the air blowing fan.

In another aspect of the disclosure an air guide included in an electric range is provided, comprising: a housing having a hollow inside, wherein air output from an air blowing fan of the electric range is supplied to one end of the housing, and a height of an upper surface of one end of the housing is greater than a height of an output end of the air blowing fan, and some of the air output from the air blowing fan is discharged through a gap between the upper surface of one end of the housing and the output end of the air blowing fan.

In an electric range according to the present disclosure, most of the air output from an air blowing fan may be delivered to a driving circuit through an air guide, and some of the air output from the air blowing fan may be discharged from the air guide and delivered to a display unit, thereby cooling all of the driving circuit and the display unit by a single air blowing fan.

In the electric range, a height of at least a part of one end of an air guide adjacent to an air blowing fan may be a height of an upper surface of the air blowing fan or greater, thereby discharging some of the air output from the air blowing fan out of the air guide and cooling a display unit using the discharged air.

In the electric range, since a single air blowing fan may cool a driving circuit and a display unit, an additional air blowing fan for cooling the display unit is not required, thereby reducing manufacturing costs and noise of an electric range.

### Advantageous Effect

According to the present disclosure, a single air blowing fan may cool all of the driving circuit and the display unit in a concentrated manner.

According to the present disclosure, noise generated during an operation may be reduced.

According to the present disclosure, costs incurred for manufacturing an electric range may be reduced.

Specific effects are described along with the above-described effects in the section of Detailed Description.

### BRIEF DESCRIPTION OF DRAWING

FIG. 1 is a view showing a related art;
FIG. 2 is a perspective view showing an induction heating device according to one embodiment;
FIGS. 3 to 6 are perspective views showing the induction heating device in FIG. 2 without some components;
FIG. 7 is a front perspective view showing an air guide according to one embodiment;
FIG. 8 is a rear perspective view showing an air guide according to one embodiment;
FIG. 9 is a lateral cross-sectional view showing an air guide according to one embodiment;
FIG. 10 is a view describing a concept of a shape in which an air blowing fan and an air guide are disposed in a case, according to one embodiment;
FIG. 11 is a perspective view showing a shape in which an air blowing fan and an air guide are connected, according to one embodiment;
FIG. 12 is a front cross-sectional view showing a shape in which an air blowing fan and an air guide are disposed, according to one embodiment;
FIG. 13 is a view describing a concept in which air output from an air blowing fan flows into an air guide, according to one embodiment;
FIG. 14 is a view showing a shape in which air is discharged from an air guide, according to one embodiment;
FIG. 15 is a view showing a shape in which a damper member is disposed on an upper surface of an air blowing fan, according to one embodiment; and
FIG. 16 is a view describing a concept in which a direction of air discharged from an air guide is changed through a damper member, according to one embodiment.

### DETAILED DESCRIPTION

The above-described aspects, features and advantages are specifically described hereunder with reference to the accompanying drawings such that one having ordinary skill in the art to which the present disclosure pertains can easily implement the invention of the disclosure. In the *disclosure, detailed description* of known technologies in relation to the disclosure *is* omitted if it is deemed to *make* the *gist* of the *disclosure* unnecessarily *vague.* Below, preferred embodiments according to the disclosure are specifically described with reference to the accompanying drawings. In the drawings, identical reference numerals can denote identical or similar components.

The terms "first", "second" and the like are used herein only to distinguish one component from another component. Thus, the components should not be limited by the terms. Certainly, a first component can be a second component unless stated to the contrary.

When one component is described as being "in an upper portion (or a lower portion)" of another component, or "on (or under)" another component, one component can be placed on the upper surface (or under the lower surface) of another component, and an additional component may be interposed between another component and one component on (or under) another component.

When one component is described as being "connected", "coupled", or "connected" to another component, one component can be directly connected, coupled or connected to another component; however, it is also to be understood that an additional component can be "interposed" between the two components, or the two components can be "connected", "coupled", or "connected" through an additional component.

Throughout the disclosure, each component can be provided as a single one or a plurality of ones, unless explicitly stated to the contrary.

The singular forms "a", "an" and "the" are intended to include the plural forms as well, unless explicitly indicated otherwise. It should be further understood that the terms "comprise" or "have," set forth herein, are not interpreted as necessarily including all the stated components or steps but can be interpreted as including some of the stated components or steps or can be interpreted as further including additional components or steps.

Throughout the disclosure, the terms "A and/or B" as used herein can denote A, B or A and B, and the terms "C to D" can denote C or greater and D or less, unless stated to the contrary.

Below, an electric range is described with reference to several embodiments.

The electric range in the disclosure may include an electric resistance-type electric range and an induction heating-type electric range (i.e., an induction heating device). For convenience, an induction heating device, provided with a working coil as a heating unit, is described as an example during description of the embodiments. However, embodiments are not limited to those set forth herein.

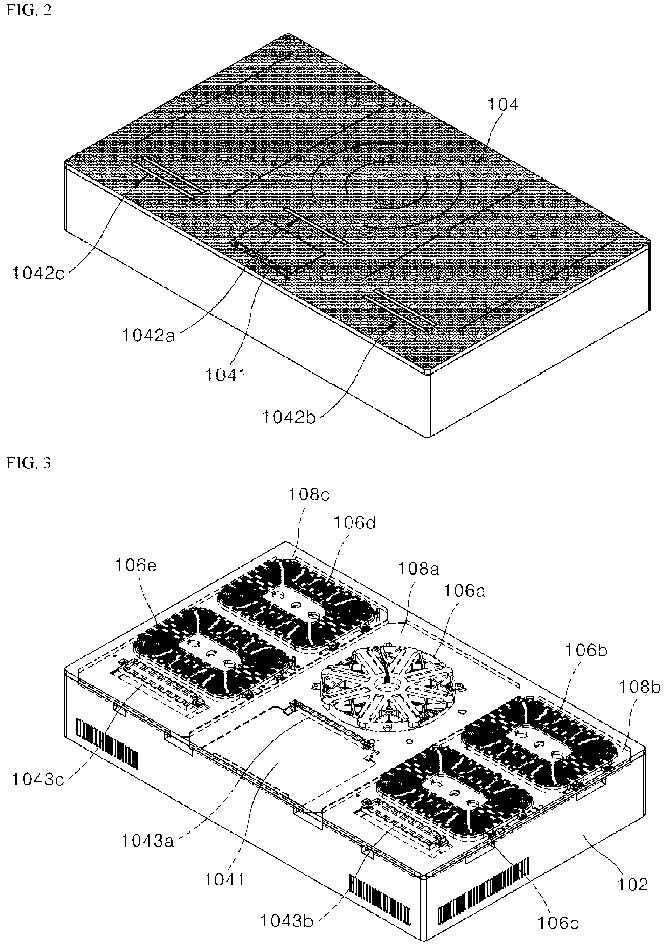

FIG. 2 is a perspective view showing an induction heating device 100 according to one embodiment. FIGS. 3 to 6 are perspective views showing the induction heating device 100 in FIG. 2 without some components.

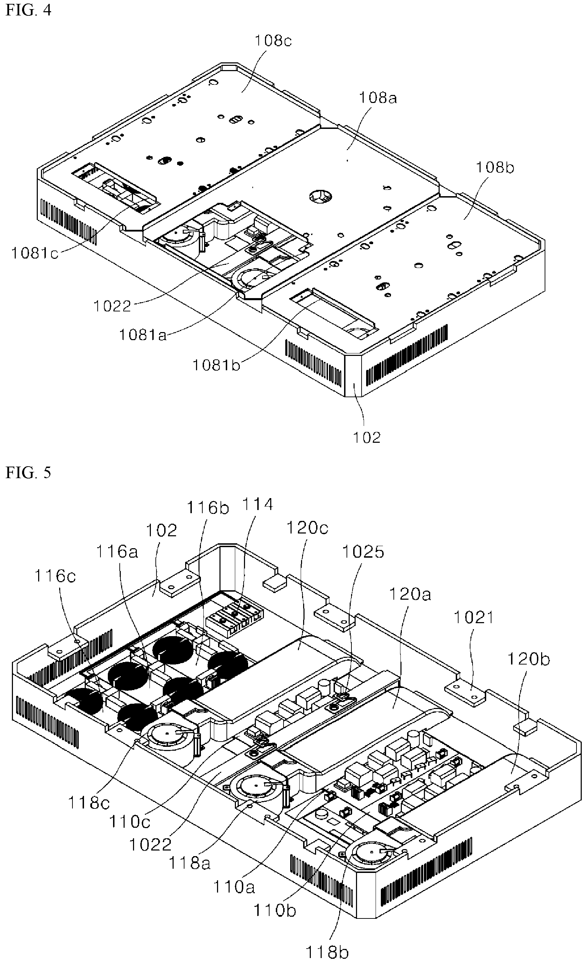

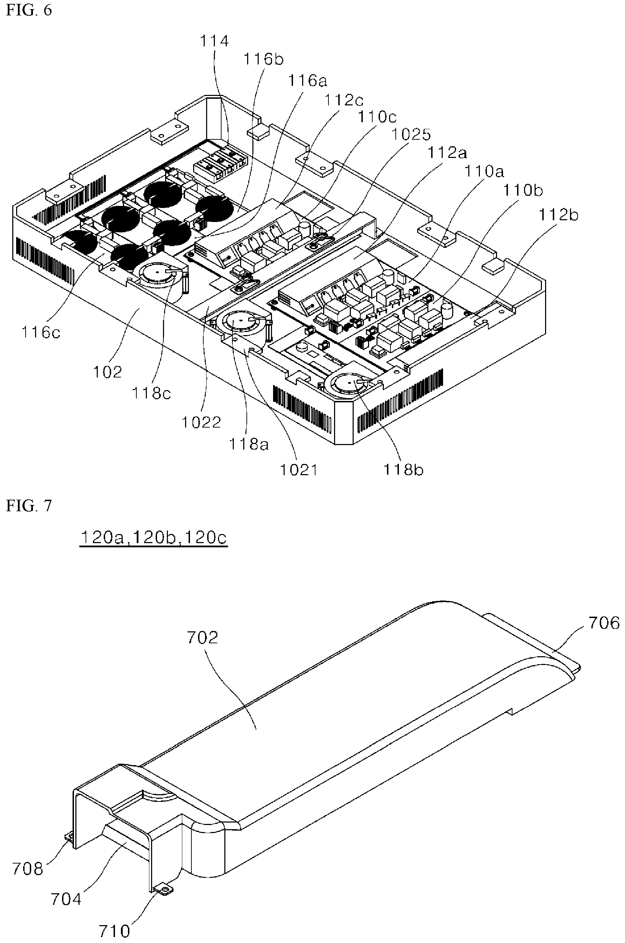

Specifically, FIG. 3 is a view showing the induction heating device 100 in FIG. 2 without a cover plate 104, FIG. 4 is a view showing the induction heating device 100 in FIG. 2 without a cover plate 104 and a working coil 106a, 106b, 106c, 106d, 106e, FIG. 5 is a view showing the induction heating device 100 in FIG. 2 without a cover plate 104, a working coil 106a, 106b, 106c, 106d, 106e, and a base plate 108a, 108b, 108c, and FIG. 6 is a view showing the induction heating device 100 in FIG. 2 without a cover plate 104, a working coil 106a, 106b, 106c, 106d, 106e, a base plate 108a, 108b, 108c and an air guide 120a, 120b, 120c.

Referring to FIGS. 2 to 6, the induction heating device 100 according to one embodiment includes a case 102, a cover plate 104, a working coil 106a, 106b, 106c, 106d, 106e, a base plate 108a, 108b, 108c, a driving circuit 110a, 110b, 110c, a heat sink 112a, 112b, 112c, a power feeder 114, a filter circuit 116a, 116b, 116c, an air blowing fan 118a, 118b, 118c, and an air guide 120a, 120b, 120c.

The case 102 may protect components in the induction heating device 100. For example, the case 102 may be made of aluminum or any other metal but not limited. The case 102 may be thermally insulated to prevent heat, generated by the working coil 106a, 106b, 106c, 106d, 106e, from leaking outward and to prevent the user from being hurt.

The cover plate 104 may be coupled to an upper end of the case 102 to shield an inside of the case 102, and an object to be heated (not illustrated, an object to be heated by one or more working coils 106a, 106b, 106c, 106d, 106e) may be placed on an upper surface of the cover plate 104.

An object to be heated such as a cooking vessel may be placed on the upper surface of the cover plate 104, and heat generated by the working coil 106a, 106b, 106c, 106d, 106e may be delivered to the object to be heated through the upper surface of the cover plate104.

The cover plate 104 may be made of glass but not limited.

An input interface 1041 configured to receive an input from a user may be disposed on the upper surface of the cover plate 104. The input interface 1041 may be buried into the upper surface of the cover plate 104 and may display a specific image. The input interface 1041 may receive a touch input from the user, and the induction heating device 100 may be driven based on the received touch input. The input interface 1041 might also include buttons or knobs being located at the case 102 or outer housing of the induction heating device 100.

Specifically, the input interface 1041 may be a module for controlling the operation of the the induction heating device 100, in particular for inputting a heating intensity or a heating period and the like desired by the user, and may be implemented as a physical button and/or a touch panel and the like. Additionally, the input interface 1041 may display a driving state or other information related to the operation of the induction heating device 100.

For example, the input interface 1041 may be a liquid crystal display (LCD) or an LED, but not limited.

One or more light display areas 1042a, 1042b, 1042c may be formed on the upper surface of the cover plate 104. One or more light source units 1043a, 1043b, 1043c may be disposed below the cover plate 104, and light emitted from the one or more light source units 1043a, 1043b, 1043c may be delivered to the user through the one or more light display areas 1042a, 1042b, 1042c.

The at least two working coils 106a, 106b, 106c, 106d, 106e may form a heating unit that heats an object to be heated, which is to be placed on the upper cover, The heating unit may be disposed in the case 102.

Each working coil 106a, 106b, 106c, 106d, 106e may include a wire that is wound multiple times in a ring shape, and may generate an AC magnetic field. Additionally, a mica sheet and/or a ferrite core may be consecutively disposed on a lower side of the working coil 106a, 106b, 106c, 106d, 106e.

The ferrite core may diffuse the AC magnetic field generated by the working coil 106a, 106b, 106c, 106d, 106e.

The ferrite core may be fixed to the mica sheet through a sealant.

The mica sheet may be fixed to the working coil 106a, 106b, 106c, 106d, 106e and the ferrite core through a sealant.

The mica sheet may prevent a direct delivery of the heat, generated by the working coil 106a, 106b, 106c, 106d, 106e, to the ferrite core.

A plurality of working coils 106a, 106b, 106c, 106d, 106e may be provided. The plurality of working coils 106a, 106b, 106c, 106d, 106e may include a first working coil 106a disposed in a central portion of the case 102, a second working coil 106b and a third working coil 106c disposed on a right side of the first working coil 106a, and a fourth working coil 106d and a fifth working coil 106e disposed on a left side of the first working coil 106a.

The second working coil 106b and the third working coil 106c may be disposed on the right side of the first working coil 106a in an up-down direction, and the fourth working coil 106d and the fifth working coil 106e may be disposed on the left side of the first working coil 106a in the up-down direction.

For example, the first working coil 106a may be a high-output dual heating coil.

The second working coil 106b, the third working coil 106c, the fourth working coil 106d and the fifth working coil 106e may be a single heating coil. The second working coil 106b, the third working coil 106c, the fourth working coil 106d and the fifth working coil 106e may have a circle or oval form. **In** particular the form may have straight portions being connected with curved portions.

Some or all of the single heating coils may have the size.

The first working coil 106a may have a circular form.

The first working coil 106a as a dual heating coil has a heavy weight, and/or may have a maximum output of 7000 kW.

The induction heating device 100 according to one embodiment may perform the function of wireless power transmission based on the configurations and features described above.

Technologies for wirelessly supplying power have been developed and have been used for a wide range of electronic devices. A battery of an electronic device, to which the wireless power transmitting technology is applied, can be charged only by being placed on a charge pad without connecting to an additional charge connector. Accordingly, the electronic device, to which the wireless power transmitting technology is applied, requires no cord or no charger, thereby ensuring improved mobility and a reduced size and weight.

The wireless power transmitting technology can be broadly classified as an electromagnetic induction technology using a coil, a resonance technology using resonance, and a radio emission technology for converting electric energy into microwaves and delivering the microwaves, and the like. In the electromagnetic induction technology, power is transmitted using electromagnetic induction between a primary coil (e.g., a working coil) included in an apparatus for wirelessly transmitting power and a secondary coil included in an apparatus for wirelessly receiving power.

The theory of the induction heating technology of the induction heating device 100 is substantially the same as that of the electromagnetic induction-based wireless power transmission technology, in that an object to be heated is heated using electromagnetic induction. Accordingly, the induction heating device 100 according to one embodiment may perform the function of wireless power transmission as well as the function of induction heating.

The base plate 108a, 108b, 108c may be disposed at a middle end of the case 102, and the plurality of working coils 106a, 106b, 106c, 106d, 106e may be disposed in an upper portion of the base plate108a, 108b, 108c. The base plate 108a, 108b, 108c may support the plurality of working coils 106a, 106b, 106c, 106d, 106e that are heavy, and may help the plurality of working coils 106a, 106b, 106c, 106d, 106e to be mounted.

The input interface 1041 and the one or more light source units 1043a, 1043b, 1043c may be further disposed in the upper portion of the base plate 108a, 108b, 108c.

According to one embodiment, a plurality of base plates 108a, 108b, 108c may be provided but not limited. Alternatively, a single base plate may be disposed in the case 102.

According to one embodiment, the plurality of base plates 108a, 108b, 108c may include a first base plate 108a, a second base plate 108b, and a third base plate 108c.

The first base plate 108a, the second base plate 108b, and the third base plate 108c may be disposed at the middle end of the case 102 side by side.

The first base plate 108a may be disposed in a central portion of the middle end of the case 102. The first working coil 106a may be disposed in an upper portion of the first base plate 108a.

There might be one or more mounting portions 1021 at the case 102 which provide support for the base plates 108a, 108b, 108c. The one or more mounting portions 1021 are bent inside the case 102. Thus the one or more base plates 108a, 108b, 108c can be placed thereon to provide an upper portion inside the case 102 for accommodating the working coils 106a, 106b, 106c, 106d, 106e and a lower portion for accommodating the other components, filter circuit 116a, 116b, 116c, air blowing fan 118a, 118b, 118c, air guide 120a, 120b, 120c and driving circuit 110a, 110b, 110c.

The input interface 1041, and a first light source unit 1043a corresponding to the first working coil 106a may be further disposed in the upper portion of the first base plate 108a. The first base plate 108a may have one or more through holes A 1081a for installing the input interface 1041 and/or the first light source unit 1043a.

The second base plate 108b may be disposed on a right side of the first base plate 108a at the middle end of the case 102. The second working coil 106b and the third working coil 106c may be disposed in an upper portion of the second base plate 108b.

A second light source unit 1043b corresponding to the second working coil 106b and the third working coil 106c may be further disposed in the upper portion of the second base plate 108b. In the upper portion of the second base plate 108b, the second working coil 106b, the third working coil 106c and the second light source unit 1043b may be consecutively disposed. The second base plate 108b may have one or more through holes B 1081b for installing one or more second light source units 1043b.

The third base plate 108c may be disposed on a left side of the first base plate 108a at the middle end of the case 102. The fourth working coil 106d and the fifth working coil 106e may be disposed in an upper portion of the third base plate108c.

A third light source unit 1043c corresponding to the fourth working coil 106d and the fifth working coil 106e may be further disposed in the upper portion of the third base plate108c. In the upper portion of the third base plate108c, the fourth working coil 106d, the fifth working coil 106e and the third light source unit 1043c may be consecutively disposed. The third base plate 108c may have one or more through holes C 1081c for installing the one or more third light source units 1043c.

The case 102 may have a plurality of mounting portions 1021 for mounting the one or more base plates 108a, 108b, 108c at a part of an outer circumferential surface of the case 102. That is, edges of the plurality of base plates 108a, 108b, 108c may be mounted onto a top of the plurality of mounting portions 1021 being bent inside the case 102. Accordingly, the plurality of base plates 108a, 108b, 108c may be disposed at the middle end of the case 102. So, there will be a space in the case 102 over and below the one or more base plates 108a, 108b, 108c. In the upper portions over the one or more base plates 108a, 108b, 108c, there are the working coils 106a, 106b, 106c, 106d, 106e and in the lower portion below the one or more base plates 108a, 108b, 108c there will be the other components of the induction heating device 100.

The case 102 may include a bracket 1022 preferably in a central portion of a lower end of the case 102. The bracket 1022 may be disposed preferably in a central portion, but at a lower side or portion of the first base plate 108a, and may prevent sagging of a lower surface of the first base plate 108a, caused by weight of the first base plate 108a. The weight of the first base plate 108a may include the weight of the first working coil 106a in the upper portion of the first base plate 108a.

The bracket 1022 may include at least one elastic element 1025 on a top of the bracket 1022 facing the lower surface of the base plate 108a, 108b, 108c. For example, the elastic element 1025 may be a leaf spring. An upper end of at least one elastic element 1025 may contact the lower surface of the first base plate 108a, and may prevent a sagging of lower surface of the first base plate 108a. Furthermore, it will keep the long side portions of the case 102 together.

The driving circuit 110a, 110b, 110c may control driving of the plurality of working coils 106a, 106b, 106c, 106d, 106e that are heating units, and may further control driving of components such as an input interface 1041 and the like of the induction heating device 100.

The driving circuit 110a, 110b, 110c may include various components in relation to the driving of the working coils 106a, 106b, 106c, 106d, 106e. The components may include at least one of a power supply configured to supply AC power, a rectifier configured to rectify AC power of the power supply into DC power, an inverter configured to convert DC power, rectified by the rectifier, into resonance current as a result of a switching operation and supply the resonance current to the working coil 106, a microcomputer (i.e., a micom) configured to control the inverter and components in relation to driving of the inverter, a relay or a semiconductor switch configured to turn on or turn off the working coils 106a, 106b, 106c, 106d, 106e, and the like.

The driving circuit 110a, 110b, 110c may include a first driving circuit 110a, a second driving circuit 110b, and a third driving circuit 110c. The first driving circuit 110a may be disposed on a right side of the lower end of the case 102 with respect to the bracket 1022 and may control driving of the first working coil 106a. The second driving circuit 110b may be disposed on the right side of the first driving circuit 110a and may control driving of the second working coil 106b and the third working coil 106c. The third driving circuit 110c may be disposed on a left side of the lower end of the case 102 with respect to the bracket 1022 and may control driving of the fourth working coil 106d and the fifth working coil 106e.

The heat sink 112a, 112b, 112c may be disposed over parts of the driving circuit 110a, 110b, 110c and may prevent an increase in temperatures of components disposed at the parts of the driving circuit 110a, 110b, 110c.

The heat sink 112a, 112b, 112c may include a first heat sink 112a, a second heat sink 112b, and a third heat sink 112c. The first heat sink 112a may prevent an increase in temperatures of components installed in a part of the first driving circuit 110a, the second heat sink 112b may prevent an increase in temperatures of components installed in a part of the second driving circuit 110b, and the third heat sink 112c may prevent an increase in temperatures of components installed in a part of the third driving circuit 110c.

The power feeder 114 may supply an external power from an external power source to the induction heating device 100. The power feeder 114 may be implemented as a terminal block.

The power feeder 114 may be disposed at any one of edges of the lower end of the case 102. For example, the power feeder 114 may be disposed at an upper end of the left side of the lower end of the case 102. The power feeder 114 is located at the same side portion of the case 102 as the filter circuits 116a, 116b, 116c.

The filter circuit 116a, 116b, 116c may be disposed at any one of the edges of the lower end of the case 102, and may reduce noise made by the plurality of working coils 106a, 106b, 106c, 106d, 106e.

The filter circuit 116a, 116b, 116c may include a first filter circuit 116a, a second filter circuit 116b, and a third filter circuit 116c.

The first filter circuit 116a may reduce noise made by the first working coil 106a. The second filter circuit 116b may reduce noise made by the second working coil 106b and the third working coil 106c. The third filter circuit 116c may reduce noise made by the fourth working coil 106d and the fifth working coil 106e.

The air blowing fan 118a, 118b, 118c may help to pull down or decrease a temperature inside the case 102. Accordingly, the air blowing fan 118a, 118b, 118c may lower a temperature of various components installed in the driving circuits 110a, 110b, 110c.

The air blowing fan 118a, 118b, 118c may be disposed at the lower side of the working coil 106a, 106b, 106c, 106d, 106e. So the air blowing fan 118a, 118b, 118c is diposed below the one or more base plates 108a, 108b, 108c.

The air blowing fan 118a, 118b, 118c may include a first air blowing fan 118a, a second air blowing fan 118b, and a third blow fan 118c.

The first air blowing fan 118a may cool various components installed in the first driving circuit 110a and may further cool the first light source unit 1043a and the input interface 1041. Particularly, the first air blowing fan 118a may deliver air (wind) for cooling to the first heat sink 112a over the first driving circuit 110a.

The second air blowing fan 118b may cool various components installed in the second driving circuit 110b and may further cool the second light source unit 1043b. Particularly, the second air blowing fan 118b may deliver air for cooling to the second heat sink 112b over the second driving circuit 110b.

The third air blowing fan 118c may cool various components installed in the third driving circuit 110c and may further cool the third light source unit 1043c. Particularly, the third air blowing fan 118c may deliver air for cooling to the third heat sink 112c over the third driving circuit 110c.

The air blowing fans 118a, 118b, 118c may not include a structure for preventing a foreign substance from contacting the air blowing fans 118a, 118b, 118c.

The air guide 120a, 120b, 120c may guide air generated by the air blowing fans 118a, 118b, 118c. The light source unit 1043a, 1043b, 1043c, the input interface 1041 and the air blowing fan 118a, 118b, 118c may be disposed on the lower side of the working coil 106a, 106b, 106c, 106d, 106e, and the air guide 120a, 120b, 120c may guide air, output from the air blowing fan 118a, 118b, 118c on a lower side of the case 102, toward an upper side of the case 102.

The air guide 120a, 120b, 120c may include a first air guide 120a, a second air guide 120b and a third guide 120c.

The first air guide 120a may be disposed to encircle the first heat sink 112a installed in a part of the first driving circuit 110a and may guide (deliver) air, output from the first air blowing fan 118a, to the first heat sink 112a.

The second air guide 120b may be disposed to encircle the second heat sink 112b installed in a part of the second driving circuit 110b and may guide air, output from the second air blowing fan 118b, to the second heat sink 112b.

The third air guide 120c may be disposed to encircle the third heat sink 112c installed in a part of the third driving circuit 110c and may guide air, output from the third air blowing fan 118c, to the third heat sink 112c.

The induction heating device 100 according to one embodiment has the configurations and features described above. Below, a shape of the air guide 120a, 120b, 120c, and a configuration for preventing air, output from the air blowing fan 118a, 118b, 118c, from escaping out of the air guide 120a, 120b, 120c are specifically described.

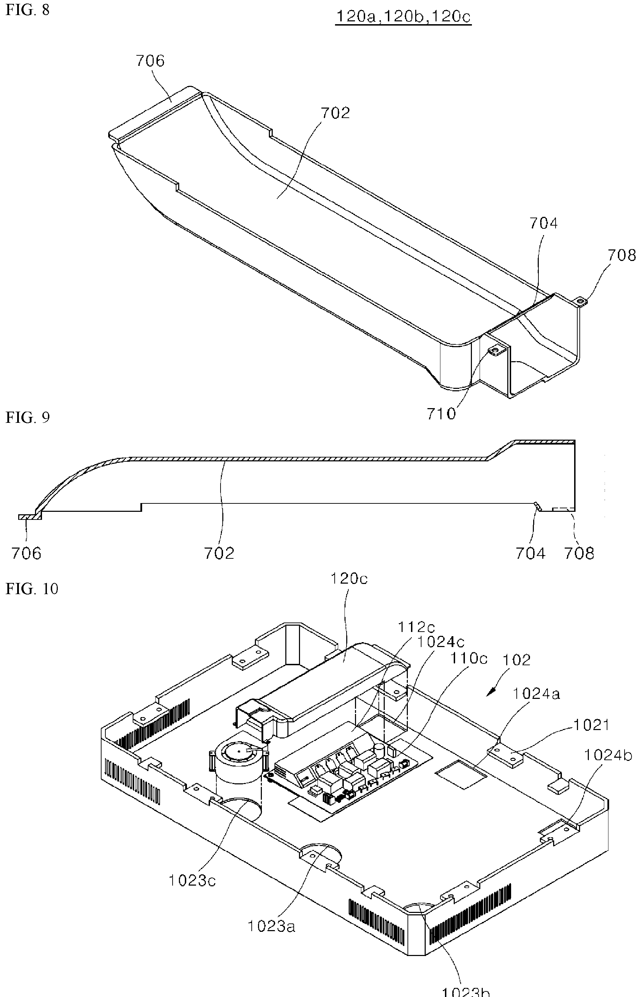

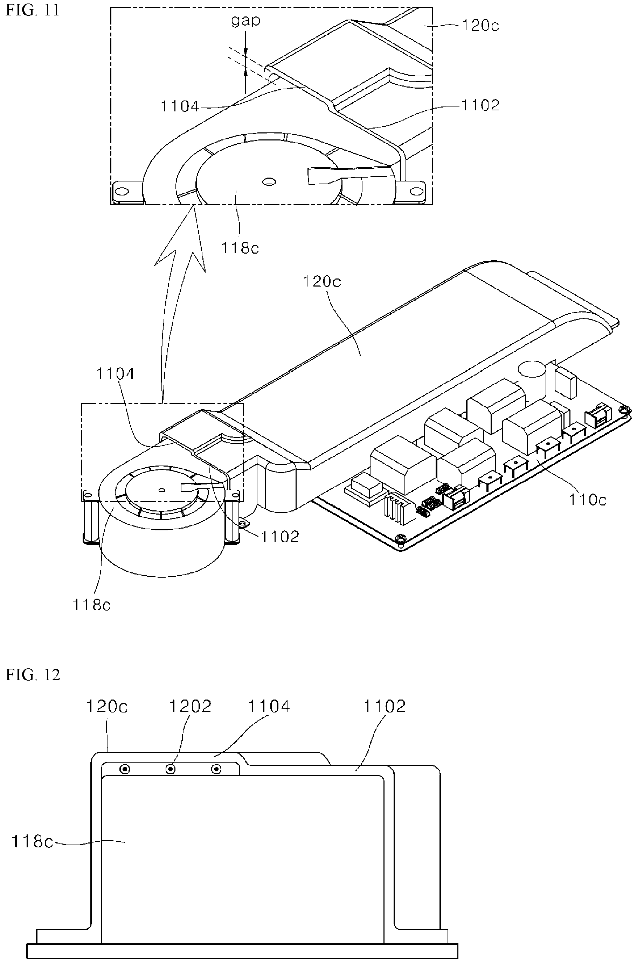

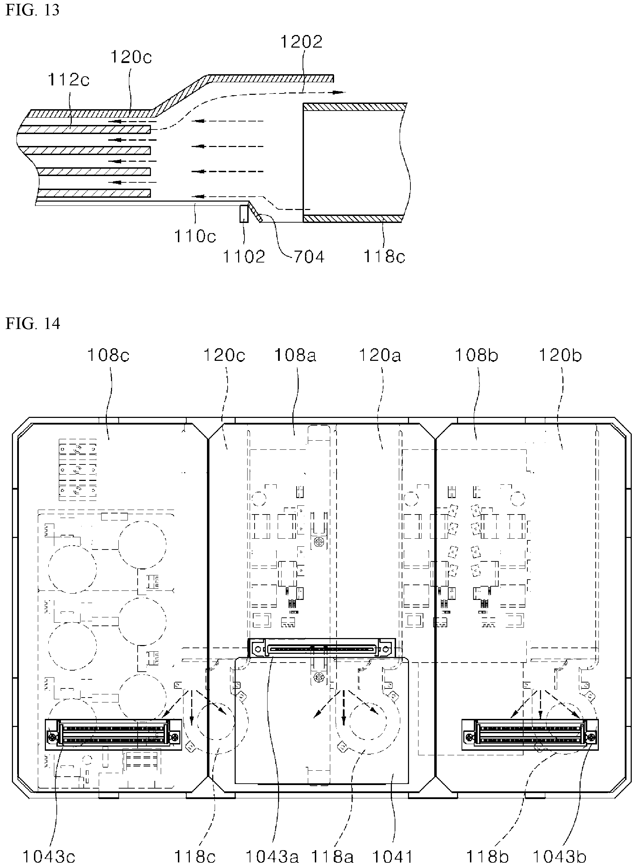

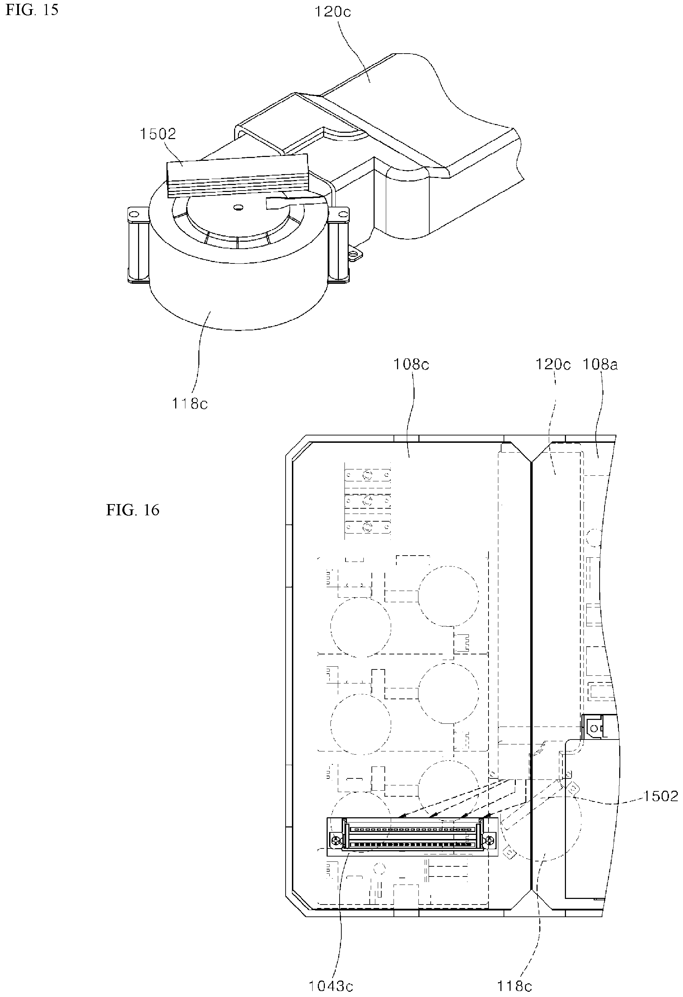

FIG. 7 is a front perspective view showing an air guide 120a, 120b, 120c according to one embodiment. FIG. 8 is a rear perspective view showing an air guide 120a, 120b, 120c according to one embodiment. FIG. 9 is a lateral cross-sectional view showing an air guide 120a, 120b, 120c according to one embodiment. FIG. 10 is a view describing a concept of a shape in which an air blowing fan 118a, 118b, 118c and an air guide 120a, 120b, 120c are disposed in a case 102, according to one embodiment. FIG. 11 is a perspective view showing a shape in which an air blowing fan 118a, 118b, 118c and an air guide 120a, 120b, 120c are connected, according to one embodiment. FIG. 12 is a front cross-sectional view showing a shape in which an air blowing fan 118a, 118b, 118c and an air guide 120a, 120b, 120c are disposed, according to one embodiment. FIG. 13 is a view describing a concept in which air output from an air blowing fan 118a, 118b, 118c flows into an air guide120a, 120b, 120c, according to one embodiment. FIG. 14 is a view showing a shape in which air is discharged from an air guide 120a, 120b, 120c, according to one embodiment. FIG. 15 is a view showing a shape in which a damper member 1502 is disposed on an upper surface of an air blowing fan 118a, 118b, 118c, according to one embodiment. FIG. 16 is a view describing a concept in which a direction of air discharged from an air guide 120a, 120b, 120c is changed through a damper member 1502, according to one embodiment.

For convenience of description, FIG. 10 to 13 show only a way in which the third air guide 120c is disposed over the third driving circuit 110c in the case 102.

Referring to FIG. 10, a first through hole 1023a, 1023b, 1023c and a second through hole 1024a, 1024b, 1024c may be formed at the lower end of the case 102. The case 102 may have a shape in which the lower end of the case 102 is closed except for the first through hole 1023a, 1023b, 1023c and the second through hole 1024a, 1024b, 1024c.

The first through hole 1023a, 1023b, 1023c may serve as a passage through which air is supplied to the air blowing fans 118a, 118b, 118c.

The first through hole 1023a, 1023b, 1023c may be formed on the lower surface of the case 102 near lower ends of the air blowing fans 118a, 118b, 118c. Accordingly, air may be supplied to the air blowing fans 118a, 118b, 118c.

The first through hole 1023a, 1023b, 1023c may be formed at an edge of the lower side of the case 102. The number of the first through holes 1023a, 1023b, 1023c may be the same as that of the air blowing fans 118a, 118b, 118c. That is, a (1-1)th through hole 1023a may provide a passage through which air is supplied to the first air blowing fan 118a, a (1-2)th through hole 1023b may provide a passage through which air is supplied to the second air blowing fan 118b, and a (1-3)th through hole 1023c may provide a passage through which air is supplied to the third air blowing fan 118c. The (1-1)th through hole 1023a, (1-2)th through hole 1023b and (1-3)th through hole 1023c may be disposed side by side at the edge of the lower side.

The first through hole 1023a, 1023b, 1023c may have a shape corresponding to a shape of a lower surface of the air blowing fan 118a, 118b, 118c. That is, the shape of the first through hole 1023a, 1023b, 1023c may be the same as a shape of a fan in the air blowing fan 118a, 118b, 118c but not limited.

The second through hole 1024a, 1024b, 1024c may serve as a passage through which air output from the air blowing fan 118a, 118b, 118c is discharged out of the case 102. That is, air in the case 102 may be discharged outward through the second through hole 1024a, 1024b, 1024c.

The air guides 120a, 120b, 120c configured to guide air generated by the air blowing fans 118a, 118b, 118c may be disposed at the lower end of the case 102. One end of the air guide 120a, 120b, 120c may be disposed near the air blowing fan 118a, 118b, 118c, and the other end of the air guide 120a, 120b, 120c may contact and connect to the lower surface of the case 102.

The second through hole 1024a, 1024b, 1024c may be formed on an edge of the upper side of the case 102. The second through hole 1024a, 1024b, 1024c may be connected to the other end of the air guide 120a, 120b, 120c, and accordingly, air may be discharged out of the case 102.

The second through hole 1024a, 1024b, 1024c may have a shape corresponding to a shape of the other end of the air guide 120a, 120b, 120c. That is, the shape of the second through hole 1024a, 1024b, 1024c may be the same as that of the other end of the air guide 120a, 120b, 120c.

The number of the second through holes 1024a, 1024b, 1024c may be the same as that of the air guides 120a, 120b, 120c. A (2-1)th through hole 1024a may connect to the first air guide 120a and provide a passage through which air is discharged, a (2-2)th through hole 1024b may connect to the second air guide 120b and provide a passage through which air is discharged, and a (2-3)th through hole 1024c may connect to the third air guide 120a and provide a passage through which air is discharged. The (2-1)th through hole 1024a, (2-2)th through hole 1024b and (2-3)th through hole 1024c may be disposed side by side at the edge of the upper side of the case 102.

Referring to FIG. 4 and FIGS. 7 to 12, the air guide 120a, 120b, 120c includes a housing 702, and may include a first member 704, a first connecting portion 706, a second connecting portion 708 and a third connecting portion 710. The air guide 120a, 120b, 120c may be integrally formed through single processing.

The housing 702 may constitute a body of the air guide 120a, 120b, 120c. The housing 702 has a hollow inside. The housing 702 may be made of a plastic material but not limited.

The housing 702 has one end, a middle end, and the other end.

One end of the housing 702 may be disposed near the air blowing fan 118a, 118b, 118c disposed on the lower side of the case 102. Air output from the air blowing fan 118a, 118b, 118c may be supplied to one end of the air guide 120a, 120b, 120c. For example, a part of one end of the housing 702 may be disposed to overlap a part of an output end of the air blowing fan 118a, 118b, 118c.

Referring to FIG. 9, one end of the housing 702 may have a rectangular shape, in the lateral cross-sectional view.

Referring to FIGS. 11 and 12, a height of at least a part of an upper surface of one end of the housing 702 may be greater than a height of the air blowing fan 118a, 118b, 118c.

Specifically, the upper surface of one end of the housing 702 includes a first portion 1102 and a second portion 1104. The first portion 1102 and the second portion 1104 of one end of the housing 702 may be formed by connecting to each other. For example, the first portion 1102 of one end of the housing 702 may be a right portion of the upper surface of one end of the housing 702, and the second portion 1104 of one end of the housing 702 may be a left portion of the upper surface of one end of the housing 702.

The first portion (the right portion) 1102 of one end of the housing 702 is disposed in contact with an upper surface of the air blowing fan 118a, 118b, 118c. That is, the first portion 1102 of one end of the housing 702 may be mounted onto the upper surface of the air blowing fan 118a, 118b, 118c.

A height of the second portion (the left portion) 1104 of one end of the housing 702 may be greater than the height of the upper surface of the air blowing fan 118a, 118b, 118c. In this case, a gap is formed between the second portion 1104 of one end of the housing 702 and the upper surface of the air blowing fan 118a, 118b, 118c. Some of the air 1202 output from the air blowing fan 118a, 118b, 118c may be discharged through the gap.

That is, most of the air output from the air blowing fan 118a, 118b, 118c may be delivered to a part (i.e., a portion where the heat sink 112a, 112b, 112c is disposed) of the driving circuit 110a, 110b, 110c through the air guide 120a, 120b, 120c, and some of the air 1202 output from the air blowing fan 118a, 118b, 118c may be discharged through the gap in a direction opposite to a direction in which most of the air is delivered.

The air 1202, discharged through the gap formed in the second portion 1104 of one end of the housing 702, may be delivered to the light source unit 1043a, 1043b, 1043c and the input interface 1041 in a concentrated manner, and based on the discharged air 1202, the light source unit 1043a, 1043b, 1043c and the input interface 1041 may be cooled.

The first member 704 may be formed at one end of the housing 702. The first member 704 may prevent the air, output from the air blowing fan 118a, 118b, 118c, from flowing into a space between the lower surface of the case 102 and the driving circuit 110a, 110b, 110c.

The driving circuit 110a, 110b, 110c may be spaced a first predetermined distance apart from the lower surface of the case 102 for reasons of insulation and the like. That is, the case 102 may have a boss 1102, protruding upward from the lower surface of the case 102, on the lower surface thereof, and the driving circuit 110a, 110b, 110c may be disposed on the boss 1102. The air blowing fan 118a, 118b, 118c may be disposed in contact with the lower surface of the case 102. In this case, the first member 704 formed at a lower end of one end of the air guide 120a, 120b, 120c may prevent the air, output from the air blowing fan 118a, 118b, 118c, from flowing into a space between the lower surface of the case 102 and the driving circuit 110a, 110b, 110c.

A middle end of the housing 702 may be disposed in a way that encircles a part of the driving circuit 118a, 118b, 118c. That is, the heat sink 112a, 112b, 112c may be disposed over a part of the driving circuit 118a, 118b, 118c, and may be disposed inside the middle end of the housing 702. Both sides of the middle end of the housing 702 may be disposed in contact with an upper surface of the driving circuit 118a, 118b, 118c. The heat sink 112a, 112b, 112c may be cooled based on air flowing at the middle end of the housing 702. Particularly, both sides of a middle end of the air guide 120a, 120b, 120c may be disposed in contact with the upper surface of the driving circuit 110a, 110b, 110c. Accordingly, air may be prevented from leaking outward from between the middle end of the air guide 120a, 120b, 120c and the upper surface of the driving circuit 110a, 110b, 110c.

Referring to FIG. 9, the first portion 1102 at one end of the middle end of the housing 702 may have a pentagonal shape, and the remaining portion of the middle end of the housing 702 may have rectangular shape, in the lateral cross-sectional view. One end of the first portion 1102 of the middle end of the housing 702 may connect to one end of the housing 702, and the other end of the first portion 1102 of the middle end of the housing 702 may connect to the remaining portion of the middle end of the housing 702.

The other end of the housing 702 may be disposed in contact with the lower surface of the case 102. That is, the other end of the housing 702 may connect to the second through hole 1024a, 1024b, 1024c. Air, output from the air blowing fan 118a, 118b, 118c and passing through a part of the driving circuit 118a, 118b, 118c, may be output from the other end of the housing 702.

Referring to FIG. 9, a shape of the other end of the housing 702 may correspond to a circular sector shape having a central angle of 90°, in the lateral cross-sectional view.

A first connecting portion 706 for a connection with the lower surface of the case 102, i.e., the second through hole 1024a, 1024b, 1024c, may be formed at an end of the other end of the housing 702. In this case, the first connecting portion 706 may protrude to an outside of the second through hole 1024a, 1024b, 1024c such that the second through hole 1024a, 1024b, 1024c and the other end of the housing 702 are connected.

The second connecting portion 708 and the third connecting portion 710 may be formed at one end of the housing 702. The second connecting portion 708 and the third connecting portion 710 may be formed on both sides of one end of the housing 702, and may have a coupling hole for coupling the housing 702 to the lower surface of the case 102. For example, the second connecting portion 708 and the third connecting portion 710 may be screw-coupled to the lower surface of the case 102.

Below, detailed description is provided with reference to FIGS. 12 to 14. For convenience description, FIG. 12 and FIG. 13 show the third air guide 120c and the third air blowing fan 118c only.

Most of the air output from the air blowing fan 118a, 118b, 118c may be delivered to a part, i.e., the heat sink 112a, 112b, 112c, of the driving circuit 118a, 118b, 118c through the air guide 120a, 120b, 120c. The heat sink 112a, 112b, 112c may be cooled by most of the air, described above, in a concentrated manner.

A height of the second portion 1104 of one end of the air guide 120a, 120b, 120c may be greater than the height of the upper surface of the air blowing fan 118a, 118b, 118c. Accordingly, a gap may be formed in the second portion 1104. In this case, some 1202 of the air output from the air blowing fan 118a, 118b, 118c may collides with one end of the heat sink 112a, 112b, 112c to escape out of the air guide 120a, 120b, 120c. Or, some 1202 of the air output from the air blowing fan 118a, 118b, 118c may escape by inner pressure between one end of the air guide 120a, 120b, 120c and the air blowing fan 118a, 118b, 118c. That is, some 1202 of the air may be discharged through the gap formed in the second portion 1104 in a direction opposite to a direction in which most of the air, described above, is delivered.

Some 1202 of the air, discharged through the gap, may be delivered to a display unit such as the light source unit 1043a, 1043b, 1043c, the input interface 1041 and the like, and may cool the display unit.

Particularly, speed of air delivered through a narrow passage may be higher than that of air delivered through a wide passage (Bernoulli's principle). Accordingly, in the induction heating device 100 according to the present disclosure, by forming one end of the air guides 120a, 120b, 120c into a first portion 1102 and a second portion 1104, an area of the space in which some 1202 of the air is discharged is reduced. Accordingly, speed at which some 1202 of the air is discharged is increased.

That is, one end of the air guide 120a, 120b, 120c may have a shape in which the first portion 1102 contacting the air blowing fan 118a, 118b, 118c, and the second portion 1104 spaced from the air blowing fan 118a, 118b, 118c connect to each other. In this case, air may not be discharged through the first portion 1102, and some 1202 of the air may be discharged only through the second portion 1104. Accordingly, the speed of some 1202 of the air discharged may increase and some 1202 of the air may be delivered to the display unit in a concentrated manner.

A flow of delivery of some 1202 of the air discharged to the display unit is specifically described, hereunder.

The light source unit 1043a, 1043b, 1043c and the input interface 1041 may be disposed over the air blowing fan 118a, 118b, 118c or in an adjacent area over the air blowing fan 118a, 118b, 118c.

Specifically, the first light source unit 1043a and the input interface 1041 may be disposed on a lower side of the first working coil 106a and disposed over the first blowing fan 118a. The first light source unit 1043a may be disposed at a first point where one end of the first air guide 120a and the output end of the first air blowing fan 118a are connected, and the input interface 1041 may be disposed on a lower side of the first point.

The second light source unit 1043b may be disposed on lower sides of the second working coil 106b and the third working coil 106c and disposed over the second air blowing fan 118b. The second light source unit 1043b may be disposed on a lower side of a second point where one end of the second air guide 120b and the output end of the second air blowing fan 118b are connected.

The third light source unit 1043c may be disposed on lower sides of the fourth working coil 106d and the fifth working coil 106e, and disposed in an adjacent area over the third air blowing fan 118c, i.e., over a left area of the third air blowing fan 118c. The third light source unit 1043c may be disposed on a left side of a lower side of a third point where one end of the third air guide 120c and the output end of the third air blowing fan 118c are connected.

Accordingly, air discharged from a gap between one end of the first air guide 120a and an upper surface of the first air blowing fan 118a may be delivered to the first light source unit 1043a and the input interface 1041 and may cool the first light source unit 1043a and the input interface 1041. Air discharged from a gap between one end of the second air guide 120b and the upper surface of the second air blowing fan 118b may be delivered to the second light source unit 1043b and may cool the second light source unit 1043b. Additionally, air discharged from a gap between one end of the third air guide 120c and the upper surface of the third air blowing fan 118c may be delivered to the third light source unit 1043c and may cool the third light source unit 1043c.

Most of the air discharged from the gap between one end of the first air guide 120a and the upper surface of the first air blowing fan 118a may be delivered to the first light source unit 1043a and the input interface 1041, and most of the air discharged from the gap between one end of the second air guide 120b and the upper surface of the second air blowing fan 118b may be delivered to the second light source unit 1043b. However, since the third light source unit 1043c is disposed in a left direction of the gap between one end of the third air guide 120c and the upper surface of the third air blowing fan 118c. Accordingly, some of the air discharged from the gap between one end of the third air guide 120c and the upper surface of the third air blowing fan 118c may be delivered to the third light source unit 1043c. In this case, the third light source unit 1043c may not be cooled properly.

Referring to FIGS. 15 and 16, the damper member 1502 may be attached onto the upper surface of the third air blowing fan 118c. That is, the damper member 1502 may guide air, discharged from the gap between one end of the third air guide 120c and the upper surface of the third air blowing fan 118c, to the third light source unit 1043c in a concentrated manner.

Specifically, one end of the damper member 1502 may be disposed in contact with one end of an upper surface of one end of the third air guide 120c, and the other end of the damper member 1502 may be disposed in a direction in which one end of the third light source unit 1043c is disposed.

An angle of the damper member 1502 may vary. For example, when the damper member 1502 is disposed as in FIG. 16 (i.e., in a direction of 40°), an amount of air delivered to the third light source unit 1043c may be maximized.

Accordingly, most of the air discharged from the gap between one end of the third air guide 120c and the upper surface of the third air blowing fan 118c may be delivered to the third light source unit 1043c through the damper member 1502 in a concentrated manner, and the cooling efficiency of the third light source unit 1043c may be maximized.

The air guides 120a, 120b, 120c according to one embodiment may be manufactured through single processing. Accordingly, costs incurred for manufacturing the air guides 120a, 120b, 120c may be reduced.

In the air guide 120a, 120b, 120c according to one embodiment, the first member 704 configured to prevent leakage of air may prevent air for cooling the heat sink 112a, 112b, 112c from escaping outward.

According to one embodiment, the driving circuit 110a, 110b, 110c and the display unit may all be cooled by a single air blowing fan 118a, 118b, 118c. That is, an additional fan for cooking the display unit is not required. Accordingly, noise generated during driving of the induction heating device 100 may be reduced and manufacturing costs may be reduced.

The embodiments are described above with reference to a number of illustrative embodiments thereof. However, the present disclosure is not intended to limit the embodiments and drawings set forth herein. Further, the effects and predictable effects based on the configurations in the disclosure are to be included within the range of the disclosure though not explicitly described in the description of the embodiments.

## Claims

1. An electric range, comprising:
a case (102);
a heating unit (106a, 106b, 106c, 106d, 106e) disposed in the case (102);
a driving circuit (110a, 110b, 110c) disposed in the case (102), and configured to drive the heating unit (106a, 106b, 106c, 106d, 106e);
a heat sink (112a, 112b, 112c) disposed over a part of the driving circuit (110a, 110b, 110c);
a display unit (1043a, 1043b, 1043c, 1041) disposed at an upper end of the case (102), and configured to display operation information of the heating unit (106a, 106b, 106c, 106d, 106e);
an air blowing fan (118a, 118b, 118c) disposed on a lower surface of the case (102); and
an air guide (120a, 120b, 120c) configured to guide air output from the air blowing fan (118a, 118b, 118c) to the driving circuit (110a, 110b, 110c), wherein the air guide (120a, 120b, 120c) comprises a housing (702) having a hollow inside and constituting a body of the air guide (120a, 120b, 120c), wherein the housing (702) has one end, a middle end, and an other end; and
wherein the air output from the air blowing fan (118a, 118b, 118c) is supplied to the one end of the air guide (120a, 120b, 120c), and the heat sink (112a, 112b, 112c) is disposed inside the middle end of the air guide (120a, 120b, 120c);
**characterized in that**:
the upper surface of the one end of the air guide (120a, 120b, 120c) comprises a first portion (1102) and a second portion (1104),
the first portion (1102) is disposed in contact with an upper surface of an output end of the air blowing fan (118a, 118b, 118c), and
a gap is formed between the second portion (1104) and the upper surface of the output end of the air blowing fan (118a, 118b, 118c).

2. The electric range of claim 1, wherein a height of an upper surface of the one end of the air guide (120a, 120b, 120c) is greater than a height of an upper surface of the air blowing fan (118a, 118b, 118c) and/or a height of at least a part of the one end of the air guide (120a, 120b, 120c) is greater than a height of an output end of the air blowing fan (118a, 118b, 118c).

3. The electric range of claim 1 or 2, wherein some of the air output from the air blowing fan (118a, 118b, 118c) is discharged through the gap between the upper surface of the one end of the air guide (120a, 120b, 120c) and the upper surface of the air blowing fan (118a, 118b, 118c), and supplied to the display unit (1043a, 1043b, 1043c, 1041).

4. The electric range of any one of the preceding claims, wherein the display unit (1043a, 1043b, 1043c, 1041) and the air blowing fan (118a, 118b, 118c) are disposed on a lower side the heating unit (106a, 106b, 106c, 106d, 106e), and/or
remaining of the air output from the air blowing fan (118a, 118b, 118c) is guided to the other end of the air guide (120a, 120b, 120c).

5. The electric range of any one of the preceding claims, wherein the display unit (1043a, 1043b, 1043c, 1041) is disposed over the air blowing fan (118a, 118b, 118c) or in an adjacent area over the air blowing fan (118a, 118b, 118c).

6. The electric range of any one of the preceding claims, further comprising: a damper member (1502) disposed in contact with the upper surface of the air blowing fan (118a, 118b, 118c), and configured to guide air discharged through the gap to the display unit (1043a, 1043b, 1043c, 1041).

7. The electric range of claim 6, wherein one end of the damper member (1502) is disposed in contact with one end of the upper surface of the one end of the air guide (120a, 120b, 120c), and an other end of the damper member (1502) is disposed in a direction in which one end of the display unit (1043a, 1043b, 1043c, 1041) is placed.

8. The electric range of any one of the preceding claims, wherein the middle end of the air guide (120a, 120b, 120c) is disposed to encircle a part of the driving circuit (110a, 110b, 110c).

9. The electric range of any one of the preceding claims, wherein the air, output from the air blowing fan (118a, 118b, 118c) and passing through a part of the driving circuit (110a, 110b, 110c), is output from the other end of the air guide (120a, 120b, 120c).

10. The electric range of any one of the preceding claims, wherein a through hole (1024a, 1024b, 1024c) connected to the other end of the air guide (120a, 120b, 120c) is formed on the lower surface of the case (102), and air output from the other end of the air guide (120a, 120b, 120c) is discharged out of the case (102) through the through hole (1024a, 1024b, 1024c).

11. The electric range of claim 10, wherein the some of the air is discharged through the gap by colliding with one end of the heat sink (112a, 112b, 112c) or by air pressure between the heat sink (112a, 112b, 112c) and the air blowing fan (118a, 118b, 118c) or some of the air output from the air blowing fan (118a, 118b, 118c) colliding with one end of the heat sink (112a, 112b, 112c) and then is discharged through a gap between at least a part of the one end of the air guide (120a, 120b, 120c) and the output end of the air blowing fan (118a, 118b, 118c).

12. The electric range of any one of the preceding claims, wherein the display unit (1043a, 1043b, 1043c, 1041) includes a light source unit (1043a, 1043b, 1043c) configured to emit light to a light display area formed on the cover plate (104); and an input interface (1041) buried into the upper surface of the cover plate (104), and configured to display a specific image and receive an input from a user.

## Patentansprüche

1. Elektroherd, der Folgendes umfasst:
ein Gehäuse (102);
eine Heizeinheit (106a, 106b, 106c, 106d, 106e), die im Gehäuse (102) angeordnet ist;
eine Ansteuerschaltung (110a, 110b, 110c), die im Gehäuse (102) angeordnet ist und konfiguriert ist, die Heizeinheit (106a, 106b, 106c, 106d, 106e) anzusteuern;
einen Kühlkörper (112a, 112b, 112c), der über einem Abschnitt der Ansteuerschaltung (110a, 110b, 110c) angeordnet ist;
eine Anzeigeeinheit (1043a, 1043b, 1043c, 1041), die an einem oberen Ende des Gehäuses (102) angeordnet ist und konfiguriert ist, Betriebsinformationen der Heizeinheit (105a, 106b, 106c, 106d, 106e) anzuzeigen;
ein Luftgebläse (118a, 118b, 118c), das auf einer unteren Fläche des Gehäuses (102) angeordnet ist; und
eine Luftführung (120a, 120b, 120c), die konfiguriert ist, Luft, die vom Luftgebläse (118a, 118b, 118c) ausgegeben wird, zur Ansteuerschaltung (110a, 110b, 110c) zu leiten, wobei die Luftführung (120a, 120b, 120c) ein Gehäuse (702) umfasst, das einen hohlen Innenraum aufweist und einen Körper der Luftführung (120a, 120b, 120c) bildet, wobei das Gehäuse (702) ein Ende, ein mittleres Ende und ein anderes Ende aufweist, und
wobei die Luft, die vom Luftgebläse (118a, 118b, 118c) ausgegeben wird, dem einen Ende der Luftführung (120a, 120b, 120c) zugeführt wird und der Kühlkörper (112a, 112b, 112c) im Inneren des mittleren Endes der Luftführung (120a, 120b, 120c) angeordnet ist;
**dadurch gekennzeichnet, dass**:
die obere Fläche des einen Endes der Luftführung (120a, 120b, 120c) einen ersten Abschnitt (1102) und einen zweiten Abschnitt (1104) umfasst,
der erste Abschnitt (1102) in Kontakt mit einer oberen Fläche eines Ausgangsendes des Luftgebläses (118a, 118b, 118c) angeordnet ist, und
ein Zwischenraum zwischen dem zweiten Abschnitt (1104) und der oberen Fläche des Ausgangsendes des Luftgebläses (118a, 118b, 118c) gebildet ist.

2. Elektroherd nach Anspruch 1, wobei eine Höhe einer oberen Fläche des einen Endes der Luftführung (120a, 120b, 120c) größer als eine Höhe einer oberen Fläche des Luftgebläses (118a, 118b, 118c) ist und/oder eine Höhe zumindest eines Abschnitts des einen Endes der Luftführung (120a, 120b, 120c) größer als eine Höhe eines Ausgangsendes des Luftgebläses (118a, 118b, 118c) ist.

3. Elektroherd nach Anspruch 1 oder 2, wobei ein Anteil der Luft, die vom Luftgebläse (118a, 118b, 118c) ausgegeben wird, durch den Zwischenraum zwischen der oberen Fläche des einen Endes der Luftführung (120a, 120b, 120c) und der oberen Fläche des Luftgebläses (118a, 118b, 118c) ausgelassen wird und der Anzeigeeinheit (1043a, 1043b, 1043c, 1041) zugeführt wird.

4. Elektroherd nach einem der vorhergehenden Ansprüche, wobei die Anzeigeeinheit (1043a, 1043b, 1043c, 1041) und das Luftgebläse (118a, 118b, 118c) auf einer unteren Seite der Heizeinheit (106a, 106b, 106c, 106d, 106e) angeordnet sind, und/oder
der Rest der Luft, die vom Luftgebläse (118a, 118b, 118c) ausgegeben wird, zum anderen Ende der Luftführung (10a, 120b, 120c) geleitet wird.

5. Elektroherd nach einem der vorhergehenden Ansprüche, wobei die Anzeigeeinheit (1043a, 1043b, 1043c, 1041) über dem Luftgebläse (118a, 118b, 118c) oder in einem benachbarten Bereich über dem Luftgebläse (118a, 118b, 118c) angeordnet ist.

6. Elektroherd nach einem der vorhergehenden Ansprüche, der ferner Folgendes umfasst: ein Dämpfungselement (1502), das in Kontakt mit der oberen Fläche des Luftgebläses (118a, 118b, 118c) angeordnet ist und konfiguriert ist, Luft, die durch den Zwischenraum zur Anzeigeeinheit (1043a, 1043b, 1043c, 1041) ausgelassen wird, zu leiten.

7. Elektroherd nach Anspruch 6, wobei ein Ende des Dämpfungselements (1502) in Kontakt mit einem Ende der oberen Fläche des einen Endes der Luftführung (120a, 120b, 120c) angeordnet ist und ein anderes Ende des Dämpfungselements (1502) in einer Richtung angeordnet ist, in der ein Ende der Anzeigeeinheit (1043a, 1043b, 1043c, 1041) angeordnet ist.

8. Elektroherd nach einem der vorhergehenden Ansprüche, wobei das mittlere Ende der Luftführung (120a, 120b, 120c) derart angeordnet ist, dass es einen Abschnitt der Ansteuerschaltung (110a, 110b, 110c) umgibt.

9. Elektroherd nach einem der vorhergehenden Ansprüche, wobei die Luft, die vom Luftgebläse (118a, 118b, 118c) ausgegeben wird und durch einen Abschnitt der Ansteuerschaltung (110a, 110b, 110c) strömt, vom anderen Ende der Luftführung (120a, 120b, 120c) ausgegeben wird.

10. Elektroherd nach einem der vorhergehenden Ansprüche, wobei ein Durchgangsloch (1024a, 1024b, 1024c), das mit dem anderen Ende der Luftführung (120a, 120b, 120c) verbunden ist, auf der unteren Fläche des Gehäuses (102) gebildet ist und Luft, die aus dem anderen Ende der Luftführung (120a, 120b, 120c) ausgegeben wird, durch das Durchgangsloch (1024a, 1024b, 1024c) aus dem Gehäuse (102) ausgelassen wird.

11. Elektroherd nach Anspruch 10, wobei der Anteil der Luft durch Kollidieren mit einem Ende des Kühlkörpers (112a, 112b, 112c) oder durch einen Luftdruck zwischen dem Kühlkörper (112a, 112b, 112c) und dem Luftgebläse (118a, 118b, 118c) oder einen Anteil der Luft, die vom Luftgebläse (118a, 118b, 118c) ausgegeben wird, der mit einem Ende des Kühlkörpers (112a, 112b, 112c) kollidiert und anschließend durch einen Zwischenraum zwischen zumindest einem Anteil der Luftführung (120a, 120b, 120c) und dem Ausgangsende des Luftgebläses (118a, 118b, 118c) ausgelassen wird, durch den Zwischenraum ausgelassen wird.

12. Elektroherd nach einem der vorhergehenden Ansprüche, wobei die Anzeigeeinheit (1043a, 1043b, 1043c, 1041) eine Lichtquelleneinheit (1043a, 1043b, 1043c), die konfiguriert ist, Licht zu einem Lichtanzeigebereich zu emittieren, der auf der Abdeckplatte (104) gebildet ist; und eine Eingabeschnittstelle (1041), die in der oberen Fläche der Abdeckplatte (104) versenkt ist und konfiguriert ist, ein bestimmtes Bild anzuzeigen und eine Eingabe von einem Benutzer zu empfangen, enthält.

## Revendications

1. Cuisinière électrique, comportant :
un caisson (102) ;
une unité de chauffage (106a, 106b, 106c, 106d, 106e) disposée dans le caisson (102) ;
un circuit de commande (110a, 110b, 110c) disposé dans le caisson (102) et configuré pour commander l'unité de chauffage (106a, 106b, 106c, 106d, 106e) ;
un dissipateur thermique (112a, 112b, 112c) disposé au-dessus d'une partie du circuit de commande (110a, 110b, 110c) ;
une unité d'affichage (1043a, 1043b, 1043c, 1041) disposée à une extrémité supérieure du caisson (102), et configurée pour afficher des informations de fonctionnement de l'unité de chauffage (106a, 106b, 106c, 106d, 106e) ;
un ventilateur de soufflage d'air (118a, 118b, 118c) disposé sur une surface inférieure du caisson (102) ; et
un guide d'air (120a, 120b, 120c) configuré pour guider de l'air sortant du ventilateur de soufflage d'air (118a, 118b, 118c) jusqu'au circuit de commande (110a, 110b, 110c), dans laquelle le guide d'air (120a, 120b, 120c) comporte un boîtier (702) ayant un intérieur creux et constituant un corps du guide d'air (120a, 120b, 120c), dans laquelle le boîtier (702) a une première extrémité, une extrémité centrale et une seconde extrémité ; et
dans laquelle l'air sortant du ventilateur de soufflage d'air (118a, 118b, 118c) est fourni à la première extrémité du guide d'air (120a, 120b, 120c), et le dissipateur thermique (112a, 112b, 112c) est disposé à l'intérieur de l'extrémité centrale du guide d'air (120a, 120b, 120c) ;
**caractérisée en ce que** :
la surface supérieure de la première extrémité du guide d'air (120a, 120b, 120c) comporte une première portion (1102) et une seconde portion (1104),
la première portion (1102) est disposée en contact avec une surface supérieure d'une extrémité de sortie du ventilateur de soufflage d'air (118a, 118b, 118c), et
un espace est formé entre la seconde portion (1104) et la surface supérieure de l'extrémité de sortie du ventilateur de soufflage d'air (118a, 118b, 118c).

2. Cuisinière électrique selon la revendication 1, dans laquelle une hauteur d'une surface supérieure de la première extrémité du guide d'air (120a, 120b, 120c) est supérieure à une hauteur d'une surface supérieure du ventilateur de soufflage d'air (118a, 118b, 118c) et/ou une hauteur d'au moins une partie de la première extrémité du guide d'air (120a, 120b, 120c) est supérieure à une hauteur d'une extrémité de sortie du ventilateur de ventilateur de soufflage d'air (118a, 118b, 118c).

3. Cuisinière électrique selon la revendication 1 ou 2, dans laquelle une partie de l'air sortant du ventilateur de soufflage d'air (118a, 118b, 118c) est évacuée à travers l'espace entre la surface supérieure de la première extrémité du guide d'air (120a, 120b, 120c) et la surface supérieure du ventilateur de soufflage d'air (118a, 118b, 118c), et fournie à l'unité d'affichage (1043a, 1043b, 1043c, 1041).

4. Cuisinière électrique selon l'une quelconque des revendications précédentes, dans laquelle l'unité d'affichage (1043a, 1043b, 1043c, 1041) et le ventilateur de soufflage d'air (118a, 118b, 118c) sont disposés sur un côté inférieur de l'unité de chauffage (106a, 106b, 106c, 106d, 106e), et/ou
le reste de l'air sortant du ventilateur de soufflage d'air (118a, 118b, 118c) est guidé jusqu'à la seconde extrémité du guide d'air (120a, 120b, 120c).

5. Cuisinière électrique selon l'une quelconque des revendications précédentes, dans laquelle l'unité d'affichage (1043a, 1043b, 1043c, 1041) est disposée au-dessus du ventilateur de soufflage d'air (118a, 118b, 118c) ou dans une zone adjacente au-dessus du ventilateur de soufflage d'air (118a, 118b, 118c).

6. Cuisinière électrique selon l'une quelconque des revendications précédentes, comportant en outre : un élément de registre (1502) disposé en contact avec la surface supérieure du ventilateur de soufflage d'air (118a, 118b, 118c), et configuré pour guider l'air évacué à travers l'espace jusqu'à l'unité d'affichage (1043a, 1043b, 1043c, 1041).

7. Cuisinière électrique selon la revendication 6, dans laquelle une première extrémité de l'élément de registre (1502) est disposée en contact avec une extrémité de la surface supérieure de la première extrémité du guide d'air (120a, 120b, 120c), et une seconde extrémité de l'élément de registre (1502) est disposée dans une direction dans laquelle une extrémité de l'unité d'affichage (1043a, 1043b, 1043c, 1041) est placée.

8. Cuisinière électrique selon l'une quelconque des revendications précédentes, dans laquelle l'extrémité centrale du guide d'air (120a, 120b, 120c) est disposée de manière à encercler une partie du circuit de commande (110a, 110b, 110c).

9. Cuisinière électrique selon l'une quelconque des revendications précédentes, dans laquelle l'air, sortant du ventilateur de soufflage d'air (118a, 118b, 118c) et passant à travers une partie du circuit de commande (110a, 110b, 110c), est sorti de la seconde extrémité du guide d'air (120a, 120b, 120c).

10. Cuisinière électrique selon l'une quelconque des revendications précédentes, dans laquelle un trou traversant (1024a, 1024b, 1024c) relié à la seconde extrémité du guide d'air (120a, 120b, 120c) est formé sur la surface inférieure du caisson (102), et l'air sortant de la seconde extrémité du guide d'air (120a, 120b, 120c) est évacué hors du caisson (102) à travers le trou traversant (1024a, 1024b, 1024c).

11. Cuisinière électrique selon la revendication 10, dans laquelle une partie de l'air est évacuée à travers l'espace par collision avec une extrémité du dissipateur thermique (112a, 112b, 112c) ou par une pression d'air entre le dissipateur thermique (112a, 112b, 112c) et le ventilateur de soufflage d'air (118a, 118b, 118c) ou une partie de l'air sortant du ventilateur de soufflage d'air (118a, 118b, 118c) par collision avec une extrémité du dissipateur thermique (112a, 112b, 112c) et est ensuite évacué par un espace entre au moins une partie de la première extrémité du guide d'air (120a, 120b, 120c) et l'extrémité de sortie du ventilateur de soufflage d'air (118a, 118b, 118c).

12. Cuisinière électrique selon l'une quelconque des revendications précédentes, dans laquelle l'unité d'affichage (1043a, 1043b, 1043c, 1041) inclut une unité de source de lumière (1043a, 1043b, 1043c) configurée pour émettre de la lumière vers une zone d'affichage lumineux formée sur la plaque de couvercle (104) ; et une interface d'entrée (1041) enfouie dans la surface supérieure de la plaque de couvercle (104), et configurée pour afficher une image spécifique et recevoir une entrée d'un utilisateur.
